# EUROPEAN PATENT APPLICATION

(11) **EP 4 322 223 A1**
(43) Date of publication of application: **14.02.2024**
(21) Application number: 22786259.6
(22) Date of filing: 28.06.2022
(51) Int. Cl.: H01L 29/06

(54) **SEMICONDUCTOR STRUCTURE AND MANUFACTURING METHOD THEREFOR, AND MEMORY**

(30) Priority: 21.06.2022 CN 202210708966
(71) Applicant: Changxin Memory Technologies, Inc., Hefei, Anhui 230601 (CN)
(72) Inventor: XIAO, Deyuan, Hefei, Anhui 230601 (CN); SHAO, Guangsu, Hefei, Anhui 230601 (CN)
(74) Representative: V.O.
(86) International application number: PCT/CN2022/101898
(87) International publication number: WO 2023/245697

(57) **Abstract**

Disclosed in embodiments of the present application are a semiconductor structure and a method for manufacturing the same, and a memory. The semiconductor structure comprises: a substrate, a plurality of oxide pillars, a plurality of active pillars, a first insulating layer and a storage structure. The plurality of oxide pillars are on the substrate and arranged in an array along a first direction and a second direction. Both the first direction and the second direction are parallel to a surface of the substrate, and the first direction intersects with the second direction. The first insulating layer is in a gap between the oxide pillars. Each active pillar is on a top surface of a corresponding one of the oxide pillars. The storage structure covers at least part of a side wall of the active pillar.

## Description

### CROSS-REFERENCE TO RELATED APPLICATION

The present application is based upon and claims priority to Chinese patent application No. 202210708966.5, filed on June 21, 2022 and entitled "SEMICONDUCTOR STRUCTURE AND METHOD FOR MANUFACTURING THE SAME, AND MEMORY", the disclosure of which is hereby incorporated by reference in its entirety.

### TECHNICAL FIELD

The present application relates to the technical field of semiconductors, specifically to a semiconductor structure and a method for manufacturing the same, and a memory.

### BACKGROUND

A storage array architecture of a Dynamic Random Access Memory (DRAM) is an array consisting of one Transistor (T) and one Capacitor (C) as a storage unit (i.e., a storage unit of 1T1C). A gate of the transistor is connected to a Word Line (WL), a drain of the transistor is connected to a Bit Line (BL), and a source of the transistor is connected to the capacitor.

As the size of the DRAM becomes smaller and smaller, the size of the capacitor becomes smaller. How to ensure the performance of the capacitor in the DRAM becomes an urgent problem to be solved.

### SUMMARY

In view of this, embodiments of the present application present a semiconductor structure and a method for manufacturing the same, and a memory.

According to an aspect of the present application, there is provided a semiconductor structure, which comprises: a substrate, a plurality of oxide pillars, a plurality of active pillars, a first insulating layer and a storage structure.

The plurality of oxide pillars are provided on the substrate and arranged in an array along a first direction and a second direction. Both the first direction and the second direction are parallel to a surface of the substrate, and the first direction intersects with the second direction.

The first insulating layer is located in a gap between the plurality of oxide pillars.

Each of the active pillars is provided on a top surface of a corresponding one of the oxide pillars.

The storage structure covers at least part of a side wall of the active pillar.

In the above solution, the material of the oxide pillar is the same as or different from the material of the first insulating layer.

In the above solution, each of the active pillars comprises a first sub-active-pillar and a second sub-active-pillar on the first sub-active-pillar; and an orthographic projection of the first sub-active-pillar on the substrate is within an orthographic projection of the second sub-active-pillar on the substrate.

In the above solution, the storage structure may comprise: a first conductive layer, covering a side wall of the first sub-active-pillar; a dielectric layer, covering a surface of the first conductive layer and a top surface of the first insulating layer; and a second conductive layer, located in the dielectric layer.

In the above solution, the semiconductor structure may further comprise: a plurality of transistors. A channel structure of each of the transistors is within the second sub-active-pillar, and the channel structure extends in a direction perpendicular to the surface of the substrate.

In the above solution, each of the transistors may comprise: a gate structure arranged around the second sub-active-pillar; and a source and a drain respectively arranged at two opposite ends of the second sub-active-pillar.

In the above solution, the semiconductor structure may also comprise: a plurality of bit lines, located on the transistors and in electrical contact with tops of the second sub-active-pillars.

According to another aspect of the present application, there is provided a memory, which comprises: one or more semiconductor structures as described in any of the above embodiments of the present application.

According to yet another aspect of the present application, there is provided a method for manufacturing a semiconductor structure, which may comprise the following operations.

A plurality of semiconductor pillars arranged in an array along a first direction and a second direction are formed on a substrate. Each of the semiconductor pillars comprises a first part and a second part on the first part. A maximum diameter width of the first part is less than a minimum diameter width of the second part. Both the first direction and the second direction are parallel to a surface of the substrate, and the first direction intersects with the second direction.

A support layer covering a side wall of a top region of each of the second parts is formed on tops of the semiconductor pillars.

The semiconductor pillars are oxidized, so that the first parts are completely oxidized into oxide pillars, and exposed surfaces of the second parts are oxidized to form an oxide layer.

A first insulating material is filled in a gap between the oxide pillars, to form a first insulating layer on the surface of the substrate.

The oxide layer is removed to obtain first sub-active-pillars.

A storage structure is formed at least on a side wall of the first sub-active-pillar.

In the above solution, the operation that the plurality of semiconductor pillars arranged in the array along the first direction and the second direction are formed on the substrate may comprise the following operations.

A semiconductor base is provided.

A plurality of first trenches spaced along the first direction and a plurality of second trenches spaced along the second direction are formed in the base.

A bottom of each of the first trenches and/or a bottom of each of the second trenches are/is enlarged to form the plurality of semiconductor pillars.

In the above solution, the operation that the support layer is formed may comprise the following operations. The first insulating material is filled between the plurality of semiconductor pillars, part of the first insulating material is removed by etching, and tops of the semiconductor pillars are exposed to obtain second sub-active-pillars.

A second insulating material covering surfaces of the second sub-active-pillars are deposited, to form a second insulating layer on the tops of the semiconductor pillars.

In the above solution, part of the second insulating layer is removed along the second direction to form first shallow trenches each having a bottom surface flush with a bottom surface of the second sub-active-pillar, and the first insulating material is filled in the first shallow trenches.

Part of the second insulating layer is removed along the first direction to form second shallow trenches each having a bottom surface flush with a top surface of the second sub-active-pillar, and the second insulating material is filled in the second shallow trenches

All the first insulating material filled between the semiconductor pillars is removed, and a grid-like support layer is formed on the tops of the semiconductor pillars.

In the above solution, after the support layer is formed, the semiconductor pillars are oxidized, so that the first parts of the semiconductor pillars are completely oxidized into oxide pillars, and exposed surfaces of the second parts of the semiconductor pillars are oxidized to form an oxide layer;
Then, the first insulating material is filled between the semiconductor pillars and part of the first insulating material and the oxide layer are removed by etching. The remaining first insulating material and the oxide pillars form a first insulating layer on the surface of the substrate.

In the above solution, the operation that the storage structure is formed at least on the side wall of the first sub-active-pillar may comprise the following operations.

A first conductive layer covering the side wall of the first sub-active-pillar is formed.

A dielectric layer covering a surface of the first conductive layer and a top surface of the first insulating layer is formed.

A second conductive layer is formed in the dielectric layer.

In the above solution, the operation that the first conductive layer covering the side wall of the first sub-active-pillar is formed may comprise the following operation.

The first conductive layer covering the side wall of the first sub-active-pillar is formed by a selective deposition process.

In the above solution, the method may also comprise the following operations.

The support layer is removed to expose the second sub-active-pillars.

A gate structure covering at least one side of each of the second sub-active-pillars is formed.

A source and a drain are formed respectively at two opposite ends of the second sub-active-pillar.

In the above solution, a maximum diameter width of the first part along the first direction is less than a minimum diameter width of the second part along the first direction; and/or, a maximum diameter width of the first part along the second direction is less than a minimum diameter width of the second part along the second direction.

In the embodiments of the present application, a plurality of semiconductor pillars are formed on the substrate, and each semiconductor pillar comprises the first part and the second part on the first part, so that the maximum diameter width of the first part is less than the minimum diameter width of the second part; then, the first parts of the plurality of semiconductor pillars are all oxidized into the oxide pillars through oxidation treatment, and the gap between the oxide pillars is filled with the first insulating material; finally, the corresponding active pillar is formed on the top surface of each oxide pillar, so that the active pillar is insulated from the substrate; and thus, the storage structure formed on part of the side wall of the active pillar is insulated from the substrate, so as to improve the problem of electric leakage of the storage structure and thus improve the reliability of the memory.

### BRIEF DESCRIPTION OF THE DRAWINGS

FIG. 1A is a schematic diagram of circuit connection of a DRAM transistor provided in an embodiment of the present application.
FIG. 1B is a structure diagram of a memory provided in an embodiment of the present application.
FIG. 2 is a flowchart of a method for manufacturing a semiconductor structure provided in an embodiment of the present application.
FIG. 3A to FIG. 3Q are section diagrams of a manufacturing process of a semiconductor structure provided in an embodiment of the present application.

### Descriptions about the reference signs:

300 is a semiconductor base; 301 is a first trench; 302 is a first insulating material; 303 is a second trench; 304 is a substrate; 305 is a semiconductor pillar; 3051 is a first part of the semiconductor pillar; 3052 is a second part of the semiconductor pillar; 3052a is a first sub-active-pillar; 3052b is a second sub-active-pillar; 306 is a first gap; 308 is a second insulating layer; 309 is a first shallow trench; 310 is a second shallow trench; 311 is a support layer; 312 is an oxide pillar; 313 is an oxide layer; 314 is a first insulating layer; 315 is a storage structure; 3151 is a first conductive layer; 3152 is a dielectric layer; and 3153 is a second conductive layer.

In the accompanying drawings (not necessarily drawn to scale), the similar reference signs may describe the similar parts in different views. The similar reference signs with different suffix letters may represent different examples of the similar parts. The accompanying drawings generally show, by example rather than by limitation, the embodiments discussed in the present application.

### DETAILED DESCRIPTION

For making the technical solutions and advantages of the embodiments of the present application clearer, the technical solutions of the present application are further described in details below in combination with the accompanying drawings and the embodiments. Although the exemplary implementation modes of the present application are shown in the drawings, it should be understood that the present application may be implemented in various forms and shall not be limited by the implementation modes described here. Rather, these implementation modes are provided in order to have a more thorough understanding of the present application and to be able to fully convey the scope of the present application to those skilled in the art.

The present application is more specifically described below by means of examples with reference to drawings. The advantages and features of the present application will be clearer according to the following specification and claims. It is to be noted that the accompanying drawings are all in a very simplified form with imprecise proportion to assist in illustrating the purpose of the embodiments of the present application easily and clearly.

It is understandable that the meaning of "on", "over" and "above" in the present application should be interpreted in the broadest way, so that "on" means not only that an object is on something and no intermediate feature or layer is presented therebetween (that is, the object is directly on something), but also that an object is on something and an intermediate feature or layer is presented therebetween.

In addition, for ease of description, terms relating to relative space relations, such as "on", "over", "above", "upper" and "top", may be used in the present application to describe the relationship between a component or feature and another component or feature as shown in the accompanying drawings. In addition to the orientation described in the accompanying drawings, the terms relating to relative space relations are intended to cover different orientations of a device in use or operation. A device may be oriented in other ways (rotated 90 degrees or in other orientations), and the description words relating to relative space relations used in the present application may also be explained accordingly.

In the embodiments of the present application, a term "substrate" refers to a material on which subsequent material layers are added. The substrate itself may be patterned. The material added to the top of the substrate may be patterned or may remain un-patterned. In addition, the substrate may comprise a variety of semiconductor materials, such as silicon, silicon germanium, germanium, gallium arsenide, and indium phosphide. Alternatively, the substrate may be made of non-conductive materials, such as glass, plastic, or sapphire wafer.

In the embodiments of the present application, a term "layer" refers to a material part that comprises a region with thickness. The layer may extend over the whole of a lower or upper structure, or may have a scope smaller than the scope of the lower or upper structure. Moreover, the layer may be a region of a homogeneous or heterogeneous continuous structure whose thickness is less than that of a continuous structure. For example, the layer may be between the top surface and the bottom surface of the continuous structure, or the layer may be between any pair of horizontal surfaces at the top surface and bottom surface of the continuous structure. The layer may extend horizontally, vertically and/or along an inclined surface. The layer may comprise multiple sub-layers. For example, an interconnection layer may comprise one or more conductors and contact sub-layers (in which interconnection wires and/or through-hole contacts are formed), and one or more dielectric sub-layers.

Terms "first", "second" and the like in the embodiments of the present application are adopted to distinguish similar objects and not intended to describe a specific sequence or order.

A semiconductor structure involved in the embodiments of the present application is such a structure that will be used in the subsequent processing to form at least a part of the structure of a final device. Here, the final device may comprise a memory. The memory comprises, but is not limited to, a DRAM. The DRAM is only taken as an example for description below.

It is to be noted that the description about the DRAM in the following embodiments is only used for illustrating the present application, but not used for limiting the scope of the present application.

With the development of the DRAM technology, the size of a storage unit becomes smaller and smaller, and its array architecture changes from 8F² to 6F², then to 4F². In addition, based on the requirements for ions and leakage current in the DRAM, the architecture of the memory changes from a planar array transistor to a recess gate array transistor, from the recess gate array transistor to a buried channel array transistor, and then from the buried channel array transistor to a vertical channel array transistor.

In some embodiments of the present application, whether it is the planar array transistor or the vertical channel array transistor, the DRAM is composed of multiple storage units. The structure of each storage unit is mainly composed of one transistor and one storage unit (capacitor) controlled by the transistor, that is, the DRAM comprises the architecture of 1 Transistor (T) and 1 Capacitor (C) (1T1C); and its main working principle is to use the amount of charges stored in the capacitor to represent whether a binary bit is 1 or 0.

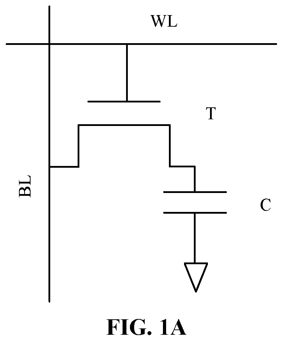

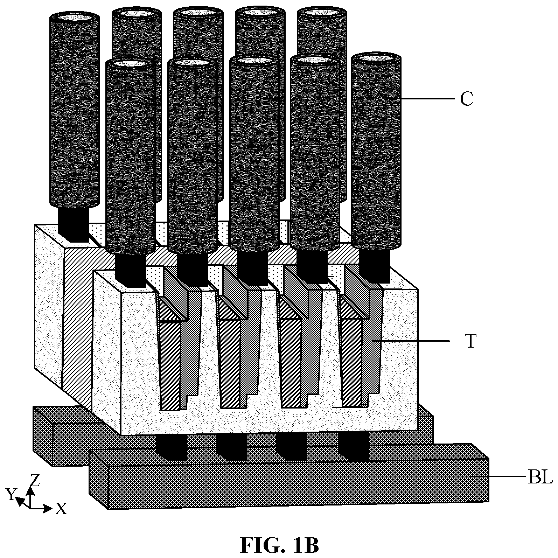

FIG. 1A is a schematic diagram of a control circuit using the architecture of 1T1C provided in an embodiment of the present application. FIG. 1B is a structure diagram of a DRAM storage array formed by transistors using the architecture of 1T1C provided in an embodiment of the present application. As illustrated in FIG. 1A and FIG. 1B, the drain of the transistor T is electrically connected to a Bit Line (BL), the source region of the transistor T is electrically connected to one electrode plate of the capacitor C, another electrode plate of the capacitor C may be connected to a reference voltage which may be a ground voltage or other voltage, and the gate of the transistor T is connected to a Word Line (WL). The voltage is applied through the WL to control the transistor T on or off. The BL is used to perform a read or write operation on the transistor T when the transistor T is on.

However, in order to realize the miniaturization of memories, the size of the DRAM keeps getting smaller, and the size of the capacitor also keeps getting smaller, which makes the process of forming the capacitor more and more difficult, so that the formed capacitor has the problem of electric leakage during use.

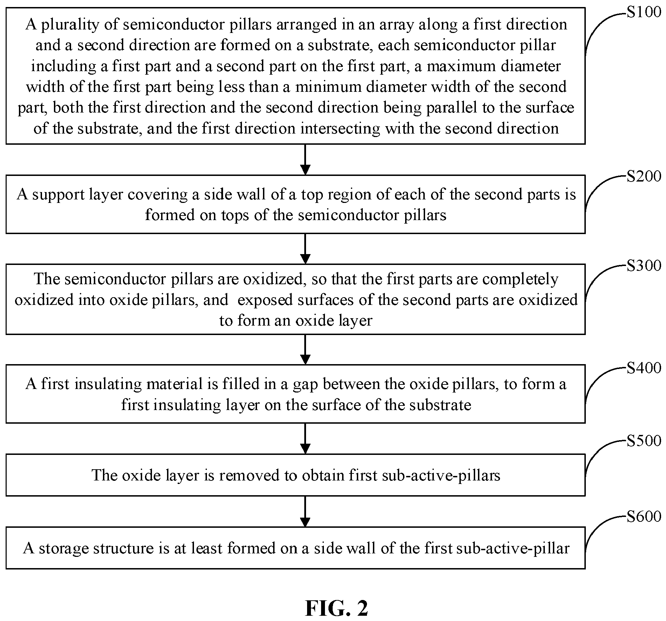

Based on this, in order to solve one or more of the above problems, the embodiments of the present application provide a method for manufacturing a semiconductor structure, which can increase the height of the capacitor, increase the storage capacity of the memory, and also reduce the process difficulty. FIG. 2 is a flowchart of a method for manufacturing a semiconductor structure provided in an embodiment of the present application. As illustrated in FIG. 2, the method for manufacturing a semiconductor structure provided in an embodiment of the present application may comprise the following steps.

At S100, a plurality of semiconductor pillars arranged in an array along a first direction and a second direction are formed on a substrate. Each of the semiconductor pillars comprises a first part and a second part on the first part. A maximum diameter width of the first part is less than a minimum diameter width of the second part. Both the first direction and the second direction are parallel to a surface of the substrate, and the first direction intersects with the second direction.

At S200, a support layer covering a side wall of a top of each of the second parts is formed on tops of the semiconductor pillars.

At S300, the semiconductor pillars are oxidized, so that the first parts are completely oxidized into oxide pillars, and exposed surfaces of the second parts are oxidized to form an oxide layer.

At S400, a first insulating material is filled in a gap between the oxide pillars, to form a first insulating layer on the surface of the substrate.

At S500, the oxide layer is removed to obtain first sub-active-pillars.

At S600, a storage structure is formed at least on a side wall of the first sub-active-pillar.

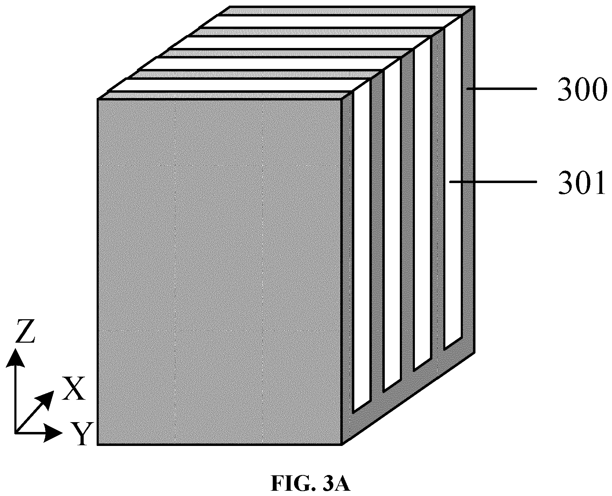

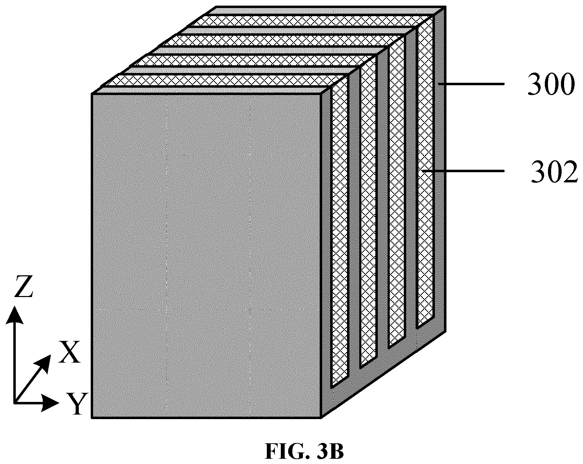

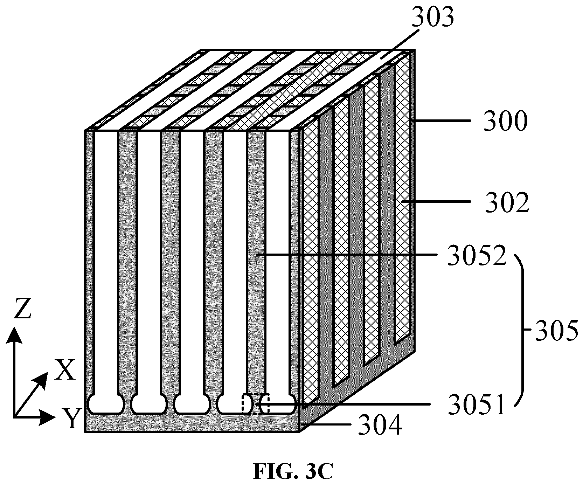

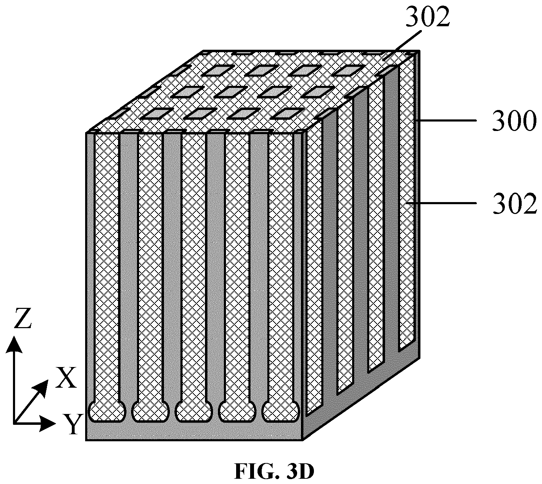

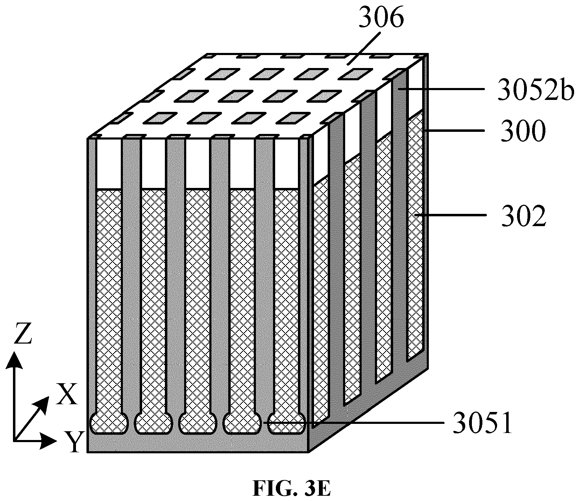

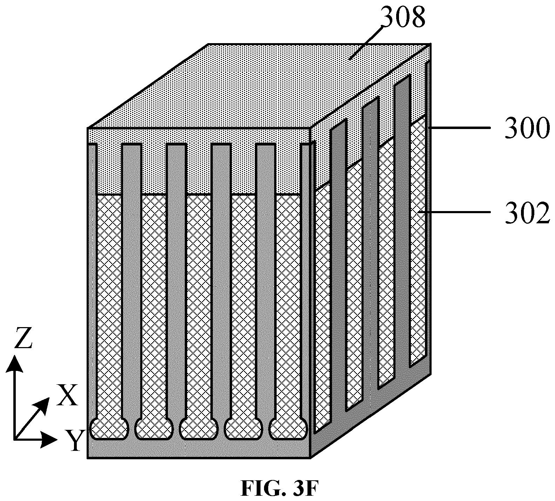

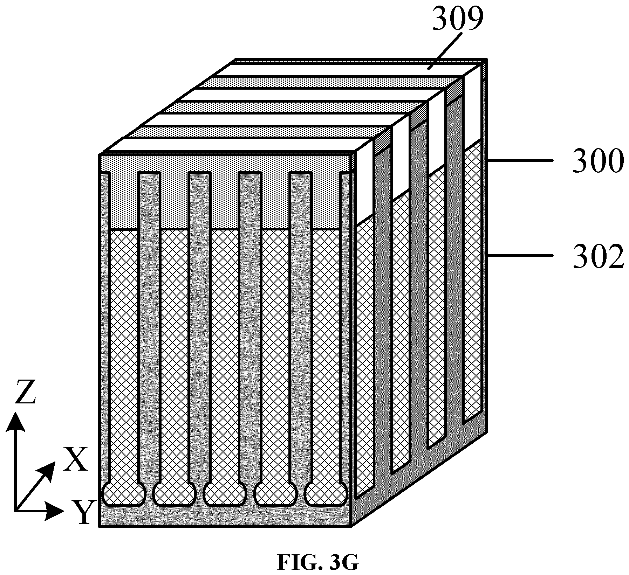

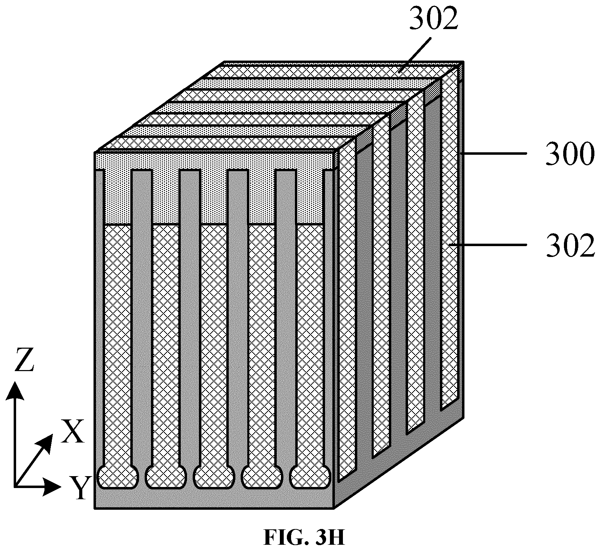

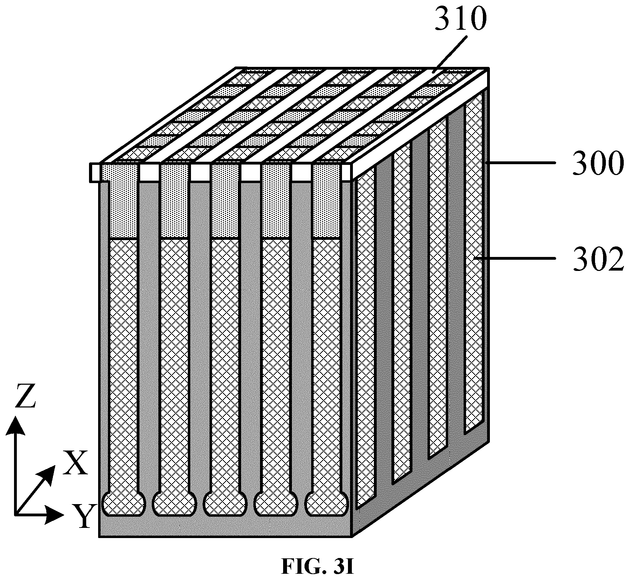

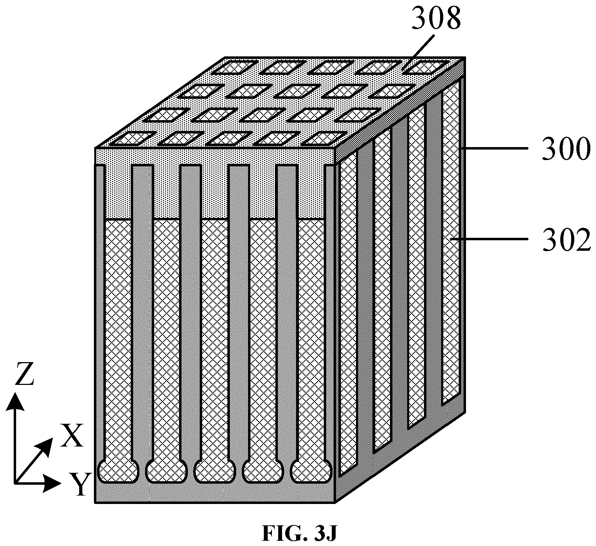

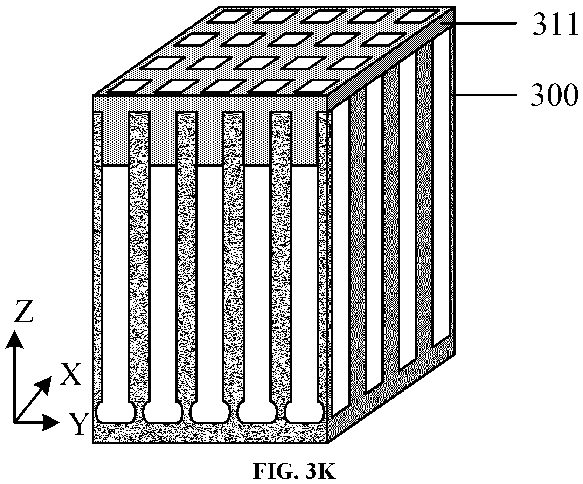

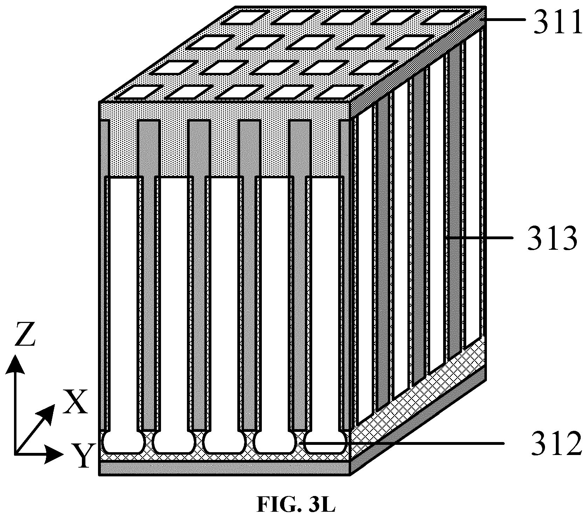

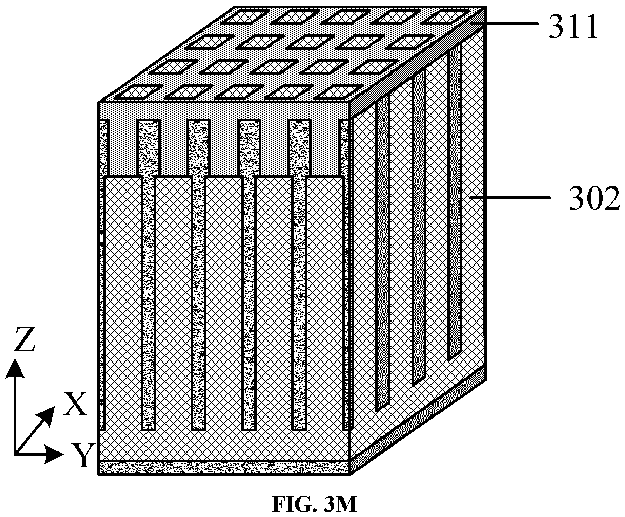

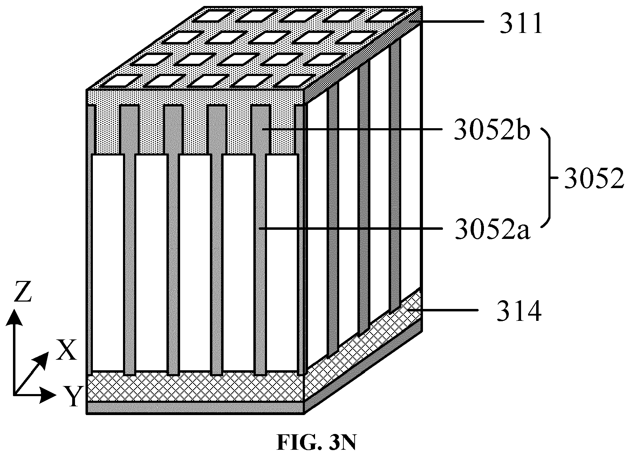

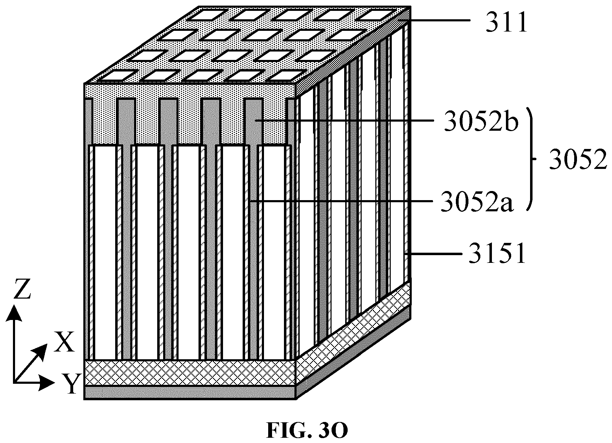

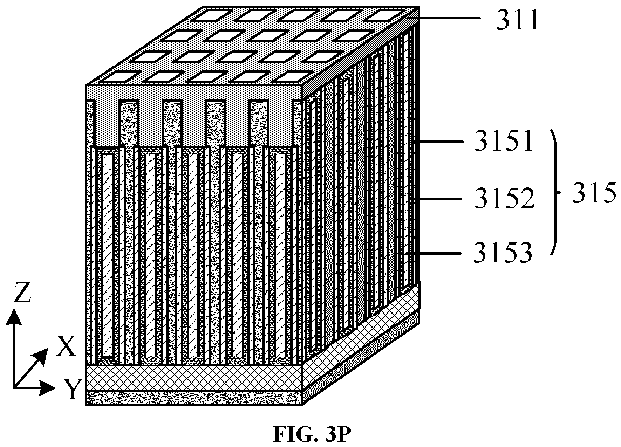

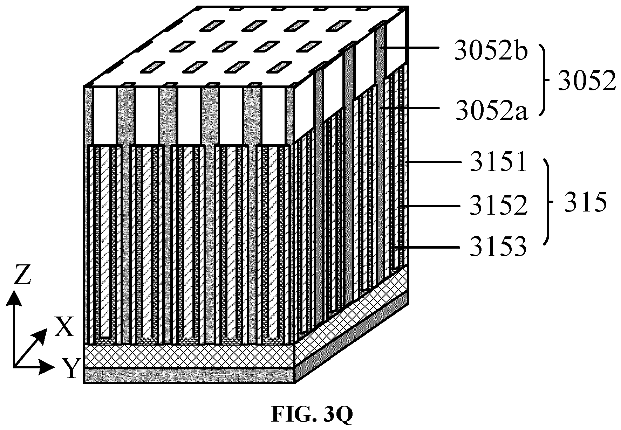

It should be understood that the steps shown in FIG. 2 are not exclusive and additional steps may also be performed before and after any step or between any steps in the illustrated operations. The sequence of the steps shown in FIG. 2 may be adjusted according to actual needs. FIG. 3A to FIG. 3Q are section diagrams of a manufacturing process of a semiconductor structure provided in an embodiment of the present application. The method for manufacturing a semiconductor structure provided by the embodiments of the present application is described in detail below in combination with FIG. 2 and FIG. 3Ato FIG. 3Q.

In S100, referring to FIG. 3A, FIG. 3B, FIG. 3C and FIG. 3D, a plurality of semiconductor pillars are formed.

The plurality of semiconductor pillars are located on the substrate and arranged in an array along the first direction and the second direction.

In some embodiments, the operation that a plurality of semiconductor pillars arranged in an array along the first direction and the second direction are formed on the substrate may comprise the following operations.

A semiconductor base is provided.

A plurality of first trenches spaced along the first direction and a plurality of second trenches spaced along the second direction are formed in the base.

A bottom of each of the first trenches and/or a bottom of each of the second trenches are/is enlarged to form the plurality of semiconductor pillars.

Here, as illustrated in FIG. 3A, materials of the semiconductor base 300 may comprise silicon (Si), germanium (Ge), silicon germanium (SiGe), and so on.

Referring to FIG. 3A, a first etching is performed on the surface of the semiconductor base 300, to form a plurality of first trenches 301 spaced along the first direction in the semiconductor base. Here, each of the first trenches 301 extends in the second direction.

It is to be noted that the first trench 301 is provided in the semiconductor base, that is, a depth of the first trench 301 along a third direction is less than a thickness of the semiconductor base 300 along the third direction.

The first direction is parallel to the surface of the semiconductor base 300. The second direction intersects with the first direction, and is parallel to the surface of the semiconductor base 300. The third direction is perpendicular to the surface of the semiconductor base 300. The third direction here may also be understood as the extension direction of the semiconductor base 300.

In other words, the first direction intersects with the second direction, that is, the included angle between the first direction and the second direction is any angle between 0 degree and 90 degrees. Here, both the first direction and the second direction are perpendicular to the third direction.

In order to describe the present application clearly, the following embodiments are described taking that the first direction is perpendicular to the second direction as an example. Exemplarily, the first direction is the X-axis direction shown in FIG. 3A; the second direction is the Y-axis direction shown in FIG. 3A; and the third direction is the Z-axis direction shown in FIG. 3A. It is to be noted that the description about the direction in the following embodiments is only used for illustrating the present application, but not for limiting the scope of the present application.

In some embodiments, the first trench 301 comprises, but is not limited to, a Shallow Trench Isolation (STI) structure.

The first etching comprises, but is not limited to, dry plasma etching.

Referring to FIG. 3B, a first insulating material 302 is formed in the first trenches 301. A top surface of the first insulating material 302 is basically flush with a top surface of the semiconductor base 300. Here, the first insulating material 302 plays a supporting role.

In some embodiments, the first insulating material 302 consists of, but is not limited to, silicon oxide (SiO₂).

Methods for forming the first insulating material 302 comprise, but are not limited to, Physical Vapor Deposition (PVD), Chemical Vapor Deposition (CVD), and so on.

Referring to FIG. 3C, a second etching is performed on the semiconductor base 300 formed with the first insulating material 302 to form a plurality of second trenches 303 in the semiconductor base 300. The plurality of second trenches 303 are spaced along the second direction, and each of the second trenches 303 extends along the first direction; that is, the first trench 301 intersects with the second trench 303.

Exemplarily, when the first direction is perpendicular to the second direction, the first trench 301 and the second trench 303 are perpendicular to each other.

Here, the second trench 303 is provided in the semiconductor base 300, that is, a depth of the second trench 303 along the third direction is less than the thickness of the semiconductor base 300 along the third direction.

Exemplarily, the plurality of second trenches 303 are spaced along the Y-axis direction; and each of the second trenches 303 extends along the X-axis direction, and the depth of each of the second trenches 303 in the Z-axis direction is less than the thickness of the semiconductor layer in the Z-axis direction.

Here, the second etching comprises, but is not limited to, dry plasma etching.

In some embodiments, the second trench 303 comprises, but is not limited to, an STI structure.

In some embodiments, the depth of the first trench 301 along the third direction may be the same as or different from the depth of the second trench 303 along the third direction.

Preferably, the depth of the first trench 301 along the third direction is the same as the depth of the second trench 303 along the third direction. In this way, the adjustment of process parameters in a manufacturing process can be reduced, and the process difficulty can be reduced.

Here, the first trenches 301 and the second trenches 303 divide the semiconductor base into a plurality of cubic pillars arranged in an array along the first direction and the second direction; and a substrate 304 is formed below the plurality of cubic pillars.

In some other embodiments, a grid-like mask layer may be formed on the surface of the semiconductor base, and the grid-like mask layer may be used as a mask to etch the semiconductor base, so as to form a plurality of cubic pillars arranged in an array along the first direction and the second direction in the semiconductor base.

Next, referring to FIG. 3C, the bottom of each of the first trenches 301 and/or the bottom of each of the second trenches 303 are/is enlarged. Here, the enlarging treatment may be understood as etching the bottom of the first trench 301 along the first direction, and/or, etching the bottom of the second trench 303 along the second direction, so that the diameter width of the bottom of the first trench 301 and/or of the bottom of the second trench 303 along the first direction is greater than the diameter width of the top of the corresponding trench along the first direction; and/or, the diameter width of the bottom of the first trench 301 and/or of the bottom of the second trench 303 along the second direction is greater than the diameter width of the top of the corresponding trench along the second direction.

Here, the used etching processes may comprise wet etching process, dry etching process, etc.

Exemplarily, in the wet etching process, an etching agent is fed into the bottom of the first trench 301 and/or the bottom of the second trench 303, and the diameter width(s) of the bottom(s) of the first trench 301 and/or the second trench 303 along the X-axis direction are/is increased by the anisotropic etching of the etching agent.

Exemplarily, in the dry etching process, the plasma is controlled to perform lateral etching, so as to form a trench structure with an enlarged diameter width at the bottom of the first trench 301 and/or the second trench 303.

In the embodiments of the present application, after the bottom of each of the first trenches 301 and/or the bottom of each of the second trenches 303 are/is enlarged, the etching process allows the bottom regions of the plurality of cubic pillars on the substrate to be etched, so the size of the bottom region of each of the cubic pillar is reduced, and then the semiconductor pillars 305 are formed, referring to FIG. 3C.

In other words, the semiconductor pillar 305 comprises the first part 3051 (as shown in the dotted box in FIG. 3C) and the second part 3052 on the first part 3051. Here, the first part 3051 of the semiconductor pillar is between the second part 3052 of the semiconductor pillar and the substrate 304.

In some embodiments, the maximum diameter width of the first part along the first direction is less than the minimum diameter width of the second part along the first direction; and/or, the maximum diameter width of the first part along the second direction is less than the minimum diameter width of the second part along the second direction.

Exemplarily, when only the first trench 301 is enlarged, the maximum diameter width of the first part 3051 of the semiconductor pillar along the X-axis direction is less than the minimum diameter width of the second part 3052 of the semiconductor pillar along the X-axis direction.

Exemplarily, when only the second trench 303 is enlarged, the maximum diameter width of the first part 3051 of the semiconductor pillar along the Y-axis direction is less than the minimum diameter width of the second part 3052 of the semiconductor pillar along the Y-axis direction.

Exemplarily, when both the first trench 301 and the second trench 303 are enlarged, the maximum diameter width of the first part 3051 of the semiconductor pillar along the X-axis direction is less than the minimum diameter width of the second part 3052 of the semiconductor pillar along the X-axis direction; and the maximum diameter width of the first part 3051 of the semiconductor pillar along the Y-axis direction is less than the minimum diameter width of the second part 3052 of the semiconductor pillar along the Y-axis direction.

Preferably, both the first trench 301 and the second trench 303 are enlarged to reduce the size of the first part of the semiconductor pillar.

Exemplarily, the maximum diameter width of the first part may be understood as the diameter width at a point where the first part 3051 of the semiconductor pillar contacts the second part 3052 of the semiconductor pillar in FIG. 3C; and the minimum diameter width of the second part may be understood as the region with the minimum size in the second part 3052 of the semiconductor pillar. Referring to FIG. 3C, the upper and lower parts of the second part 3052 of the semiconductor pillar have the same size, that is, the minimum diameter width and the maximum diameter width of the second part of the semiconductor pillar are the same.

Referring to FIG. 3D, the first insulating material 302 is formed in the second trenches 303. The top surface of the first insulating material 302 is basically flush with the top surface of the semiconductor pillar 305. The first insulating material plays a supporting role.

Exemplarily, the first insulating material 302 consists of, but is not limited to, silicon oxide.

Here, the methods for forming the first insulating material 302 comprise, but are not limited to, PVD, CVD and other processes.

It is to be noted that the sequence of forming the first trench 301 and the second trench 303 and filling the first insulating material 302 in the first trench 301 and the second trench 303 may be selected according to the actual situation. In some other specific embodiments, the first insulating material 302 may be filled in the first trench 301 and the second trench 303 after the first trench 301 and the second trench 303 are formed. Here, the first insulating material is basically flush with the top surfaces of the plurality of semiconductor pillars.

In S200, referring to FIG. 3E to FIG. 3K, a support layer is formed.

In some embodiments, the operation that the support layer is formed may comprise the following operations. Part of the first insulating material is removed by etching, and tops of the semiconductor pillars are exposed to obtain second sub-active-pillars.

A second insulating material covering surfaces of the second sub-active-pillars is deposited, to form a second insulating layer on tops of the semiconductor pillars.

Referring to FIG. 3E, part of the first insulating material 302 in the first trenches 301 and the second trenches 303 is etched to form a first gap 306, in this case, the tops of the semiconductor pillars are exposed, that is, the second sub-active-pillars 3052b are exposed. Here, the second sub-active-pillar 3052b is an end, at the side away from the first part 3051, of the second part of the semiconductor pillar.

Referring to FIG. 3F, the second insulating material is formed in the first gap by the deposition processes; then, the second insulating material is flattened to form a second insulating layer 308 on the top of the semiconductor pillars. The second insulating layer 308 covers the surfaces of the second sub-active-pillars, and the top surface of the second insulating layer 308 is higher than the top surface of the semiconductor pillar.

Here, the deposition processes comprise, but are not limited to, PVD, CVD, etc.

The flattening process comprises, but is not limited to, Chemical Mechanical Polishing (CMP).

The constituent materials of the second insulation layer 308 comprise, but are not limited to, nitride, carbide, etc.

In some embodiments, referring to FIG. 3G, part of the second insulating layer 308 is removed along the second direction to form first shallow trenches 309 each having a bottom surface flush with the bottom surface of the second sub-active-pillar, and the first insulating material 302 is filled in the first shallow trenches 309.

Part of the second insulating layer 308 is removed along the first direction to form second shallow trenches 310, a bottom surface of each of the second shallow trenches 310 being flush with the top surface of the second sub-active-pillar, and the second shallow trench 310 being directly above the second sub-active-pillar and exposing the top surface of the second sub-active-pillar; and the second insulating material is filled in the second shallow trenches 310.

All the first insulating material 302 filled between the semiconductor pillars is removed, and then a grid-like support layer 311 is formed on the tops of the semiconductor pillars.

Exemplarily, referring to FIG. 3G, the second insulating layer 308 is etched by the etching process to remove part of the second insulating layer 308 and expose part of the top of the first insulating material 302, and a plurality of first shallow trenches 309 are formed on the tops of the semiconductor pillars. The plurality of first shallow trenches 309 are spaced along the X-axis direction, and each of the first shallow trenches 309 extends along the Y-axis direction.

Here, the bottom surface of the first shallow trench 309 is basically flush with the bottom surface of the second sub-active-pillar 3052b.

Referring to FIG. 3H, the first insulating material 302 is filled in the first shallow trenches 309, so that the top surface of the first insulating material 302 in the first shallow trenches 309 is higher than the top surface of the semiconductor pillar. Here, the top surface of the first insulating material 302 in the first shallow trenches 309 is basically flush with the top surface of the remaining second insulating layer 308.

Referring to FIG. 3I, the second insulating layer 308 and the first insulating material 302 in the first shallow trenches 309 are etched by the etching processes to remove part of the second insulating layer 308 and part of the first insulating material 302 to expose part of the top surfaces of the semiconductor pillars, and a plurality of second shallow trenches 310 are formed on the top surfaces of the semiconductor pillars. The plurality of second shallow trenches 310 are spaced along the Y-axis direction, and each of the second shallow trenches 310 extends along the X-axis direction.

Here, the bottom surface of the second shallow trench 310 is basically flush with the top surface of the second sub-active-pillar 3052b, and the second shallow trench 310 is located directly above the second sub-active-pillar and exposes the top surface of the second sub-active-pillar.

It is to be noted that the "basically flush" mentioned in the embodiments of the present application may be understood as substantially flush. It is understandable that, in the process of manufacturing a memory, misalignment or non-flush due to machining errors is also comprised in the range of basically flush.

Referring to FIG. 3J, the second insulating material is filled in the second shallow trenches 310. Here, the top surface of the second insulating material in the second shallow trenches 310 is basically flush with the top surface of the second insulating layer 308.

Referring to FIG. 3K, the first insulating material 302 between the semiconductor pillars is removed, and the grid-like support layer 311 is formed on the tops of the semiconductor pillars.

Here, the constituent materials of the support layer 311 comprise, but are not limited to, nitride, carbon, etc.

Preferably, the constituent materials of the support layer 311 comprise silicon nitride.

In S300, referring to FIG. 3L and FIG. 3M, the semiconductor pillars 305 are oxidized.

In some embodiments, referring to FIG. 3L, after the support layer 311 is formed, the semiconductor pillars are oxidized, so that the first parts of the semiconductor pillars are completely oxidized into oxide pillars 312, and the exposed surfaces of the second parts of the semiconductor pillars are oxidized to form an oxide layer 313.

Referring to FIG. 3M, the first insulating material 302 is filled between the semiconductor pillars, part of the first insulating material 302 and the oxide layer 313 are removed by etching, and the remaining first insulating material 302 and the oxide pillars 312 form a first insulating layer 314 on the surface of the substrate.

Exemplarily, referring to FIG. 3L, the semiconductor pillars are oxidized by an oxidation process, so that all of the first parts 3051 of the semiconductor pillars are oxidized into the oxide pillars 312, and the exposed surfaces of the second parts of the semiconductor pillars are oxidized to form the oxide layer 313; at the same time, the surface of the substrate 304 is also oxidized to form an oxide layer.

Here, the material of the oxide pillar 312 is the same as the material of the oxide layer 313.

Exemplarily, the constituent materials of the oxide pillar 312 and the oxide layer 313 comprise, but are not limited to, silicon oxide.

In some embodiments, the material of the oxide pillar 312 is the same as or different from the material of the first insulating layer 314.

Exemplarily, the constituent materials of the first insulating layer 314 comprise, but are not limited to, silicon oxide.

Here, it is to be noted that, after the first trench 301 and/or the second trench 303 are/is enlarged in the above embodiments, the first part of the semiconductor pillar is small in size, so it is easy to be completely oxidized. When the first part of the semiconductor pillar is completely oxidized, only the surface of the second part of the semiconductor pillar is oxidized.

It is also to be noted that because the second sub-active-pillar in the second part of the semiconductor pillar is surrounded by the support layer 311, the support layer 311 may be used to protect a part, covered by the support layer 311, at the top portion of the semiconductor pillar (namely the second sub-active-pillar) from being oxidized or damaged when the first part and the second part of the semiconductor pillar are oxidized.

Referring to FIG. 3M and FIG. 3N, in S400, the first insulating layer 314 is formed; in S500, the first sub-active-pillars are obtained.

Referring to FIG. 3M, the first insulating material 302 is filled between the plurality of semiconductor pillars formed with the oxide layer 313, so that the first insulating material 302 is basically flush with the top surface of the support layer 311.

Here, the methods for filling the first insulating material 302 comprise, but are not limited to, PVD, CVD and other processes.

Referring to FIG. 3N, part of the first insulating material 302 between the plurality of the semiconductor pillars and the oxide layer 313 on the surface of the second part of each semiconductor pillar are removed by etching processes to obtain the first sub-active-pillars 3052a.

It is to be noted that the first sub-active-pillar 3052a and the second sub-active-pillar 3052b form the second part 3052 of the semiconductor pillar, and the second sub-active-pillar 3052b is located on the first sub-active-pillar 3052a.

Here, the remaining first insulating material 302 and the oxide pillars 312 form the first insulating layer 314. The first insulating layer 314 is located between the first sub-active-pillar 3052a and the substrate 304.

The etching processes comprise, but are not limited to, dry plasma etching process.

In some embodiments, an orthographic projection of the first sub-active-pillar 3052a on the substrate is within an orthographic projection of the second sub-active-pillar 3052b on the substrate.

In S600, referring to FIG. 3O, FIG. 3P and FIG. 3Q, the storage structure 315 is formed.

Here, the storage structure 315 is used for storing data. Exemplarily, the storage structure 315 comprises a capacitor.

In some embodiments, the operation that the storage structure is at least formed on the side wall of the first sub-active-pillar 3052a may comprise the following operations.

A first conductive layer 3151 covering the side wall of the first sub-active-pillar 3052a is formed.

A dielectric layer 3152 covering a surface of the first conductive layer and a top surface of the first insulating layer 314 is formed.

A second conductive layer 3153 is formed in the dielectric layer 3152.

Here, the first conductive layer is used as a lower electrode of the capacitor, the dielectric layer is used as a dielectric medium of the capacitor, and the second conductive layer is used as an upper electrode of the capacitor.

In some specific embodiments, the constituent materials of the first conductive layer 3151 may comprise, but are not limited to, ruthenium (Ru), ruthenium oxide (RuO) and titanium nitride (TiN).

In the embodiments of the present application, the first conductive layer may be formed on the side wall of the first sub-active-pillar by a selective deposition process or by other deposition processes.

The selective deposition process refers to selectively depositing the first conductive layer on the side wall of the first sub-active-pillar. Here, the other deposition processes comprise, but are not limited to, PVD, CVD, Atomic Layer Deposition (ALD) and other processes.

In some specific embodiments, the operation that the first conductive layer covering the side wall of the first sub-active-pillar 3052a is formed may comprise the following operation.

The first conductive layer covering the side wall of the first sub-active-pillar 3052a is formed by the selective deposition process.

It is to be noted that, in the embodiments of the present application, in the process of forming the first conductive layer by the selective deposition process, the material for forming the first conductive layer may be formed only on the side wall of the first sub-active-pillar 3052a or on other selected material, but not on the top surface of the first insulating layer 314, referring to FIG. 3O. In this way, on the one hand, forming the first conductive layer in the gap with a higher depth-to-width ratio is avoided, thereby reducing the process difficulty and improving the process window; on the other hand, the problem of void in the process of forming the first conductive layer by other processes may also be avoided, and thus the reliability of the semiconductor structure is improved.

Referring to FIG. 3O, the dielectric layer 3152 is formed on the surface of the first conductive layer and on the top surface of the first insulating layer 314 by the deposition processes.

The constituent materials of the dielectric layer comprise a material with high dielectric constant (high-K), which generally refers to the material with the dielectric constant higher than, and usually significantly higher than, 3.9. In some specific examples, the materials of the dielectric layer may comprise, but are not limited to, aluminum oxide (Al₂O₃), zirconium oxide (ZrO), hafnium oxide (HfO₂), strontium titanate (SrTiO₃), etc.

Referring to FIG. 3O, the second conductive layer 3153 is formed in the dielectric layer.

In some specific embodiments, the constituent materials of the second conductive layer may comprise, but are not limited to, ruthenium, ruthenium oxide and titanium nitride.

Here, the methods for forming the second conductive layer comprise, but are not limited to, PVD, CVD and other processes.

It is to be noted that the method for forming the first conductive layer and the second conductive layer in the above embodiments may also be understood as forming Conductive on Conductive (CoC) by the selective deposition process. Here, the selective deposition process comprises, but is not limited to, the ALD process.

In some embodiments, the method may further comprise the following operations.

The support layer 311 is removed to expose the second sub-active-pillars 3052b.

A gate structure covering at least one side of each of the second sub-active-pillars is formed.

A source and a drain are formed respectively at two opposite ends of the second sub-active-pillar.

Exemplarily, referring to FIG. 3P and FIG. 3Q, the support layer 311 is removed by the etching processes to expose the second sub-active-pillars 3052b.

It is to be noted that, in some other specific embodiments, when the dielectric layer is also formed at the bottom of the support layer 311, the operation that the support layer 311 is removed may also comprise removing the dielectric layer at the bottom of the support layer 311.

Here, the bottom of the support layer 311 is flush with the bottom surface of the second sub-active-pillar 3052b.

The etching processes comprise, but are not limited to, the dry plasma etching process.

Next, referring to FIG. 3Q, a gate structure (not shown in FIG. 3Q) is formed on at least one side of the second sub-active-pillar by a process.

Here, the shape of the gate varies in different types of transistors. Exemplarily, in a columnar gate transistor, the gate is formed at one side of the channel region in a columnar form; in a gate half around transistor, the gate half surrounds the channel region; and in a Gate All Around (GAA) transistor, the gate completely surrounds the channel region.

The types of transistors in the embodiments of the present application may comprise, but are not limited to, many above types. Preferably, the type of the transistor is a GAA transistor.

It is to be noted that the gate structure here comprises a Gate (G) and a gate oxide layer. The gate oxide layer is located between the gate and a channel region, and is used for electrically isolating the channel region and the gate to reduce the hot carrier effect of the transistor.

Here, the materials of the gate may comprise metal or polycrystalline silicon (Poly), etc. The materials of the gate oxide layer may comprise, but are not limited to, silicon oxide.

In some embodiments, the methods for forming the gate comprise, but are not limited to, PVD, CVD, ALD, etc. The methods for forming the gate oxide layer comprise, but are not limited to, in situ oxidation.

A source and a drain (not shown in FIG. 3Q) are formed respectively at two opposite ends of the second sub-active-pillar.

In some specific embodiments, the methods for forming the source and the drain comprise, but are not limited to, a doping process and a diffusion process.

It is to be noted that the positions of the source and the drain at the two opposite ends of the second sub-active-pillar may be interchanged, which may be selected and set according to actual requirements.

It is understandable that the memory in the above embodiments is of Transistor on Capacitor (TOC) structure. The structure also comprises a plurality of BLs which are provided on the transistor and in electrical contact with the top of the second sub-active-pillar.

Therefore, in some embodiments, the method may also comprise that a BL is formed on the transistor.

It is understandable that the BL is configured for performing a read or write operation on the transistor when the transistor is on.

Here, the BL is set above the transistor, and the BL is used as a Metal BL, which can reduce the resistance and reduce the process difficulty, and better matches a circuit design scheme of the memory.

Based on this, in the embodiments of the present application, a plurality of semiconductor pillars are formed on the substrate, and each semiconductor pillar comprises the first part and the second part on the first part, so that the maximum diameter width of the first part is less than the minimum diameter width of the second part; then, the first parts of the plurality of semiconductor pillars are all oxidized into the oxide pillars through oxidation treatment, and the gap between the oxide pillars is filled with the first insulating material. Finally, the corresponding active pillar is formed on the top surface of each oxide pillar, so that the active pillar is insulated from the substrate. Accordingly, the storage structure formed on part of the side wall of the active pillar is insulated from the substrate, so as to improve the problem of electric leakage of the storage structure and thus improve the reliability of the memory.

According to another aspect of the present application, the embodiments of the present application provide a semiconductor structure, which may comprise: a substrate, a plurality of oxide pillars, a plurality of active pillars, a first insulating layer and a storage structure.

The plurality of oxide pillars are disposed on the substrate and arranged in an array along a first direction and a second direction. Both the first direction and the second direction are parallel to the surface of the substrate, and the first direction intersects with the second direction.

The first insulating layer is located in a gap between the plurality of oxide pillars.

Each of the active pillars is provided on a top surface of a corresponding one of the oxide pillars.

The storage structure covers at least part of the side wall of the active pillar.

In some embodiments, the material of the oxide pillar is the same as or different from the material of the first insulating layer.

In some embodiments, each of the active pillars comprises a first sub-active-pillar and a second sub-active-pillar on the first sub-active-pillar; and an orthographic projection of the first sub-active-pillar on the substrate is within an orthographic projection of the second sub-active-pillar on the substrate.

In some embodiments, the storage structure may comprise: a first conductive layer, a dielectric layer and a second conductive layer.

The first conductive layer covers a side wall of the first sub-active-pillar.

The dielectric layer covers a surface of the first conductive layer and a top surface of the first insulating layer.

The second conductive layer is located in the dielectric layer.

In some embodiments, the semiconductor structure may also comprise: a plurality of transistors. A channel structure of each of the transistors is within the second sub-active-pillar, and the channel structure extends in a direction perpendicular to the surface of the substrate.

In some embodiments, the transistor may comprise: a gate structure arranged around the second sub-active-pillar; and a source and a drain respectively arranged at two opposite ends of the second sub-active-pillar.

In some embodiments, the semiconductor structure may also comprise: a plurality of BLs, located on the transistors and in electrical contact with tops of the second sub-active-pillars.

According to yet another aspect of the present application, the embodiments of the present application also provide a memory, which may comprise: one or more semiconductor structures as described in any of the above embodiments of the present application.

Based on this, in the embodiments of the present application, by setting the corresponding oxide pillar between each active pillar and the substrate, the storage structure (e.g., capacitor) formed on part of the side wall of the active pillar can be isolated, thus reducing the problem of electric leakage of the storage structure (e.g., capacitor) during use.

The characteristics disclosed in some method or device embodiments provided in the present application may be freely combined without conflicts to obtain new method embodiments or device embodiments.

The above content is only the specific implementation modes of the present application, but is not intended to limit the protection scope of the present application. Any change or replacement that those skilled in the art can think of easily in the scope of technologies disclosed by the present application shall fall within the protection scope of the present application. Therefore, the scope of protection of the present application shall be subject to the scope of protection of the claims.

### INDUSTRIAL APPLICABILITY

In the embodiments of the present application, a plurality of semiconductor pillars are formed on the substrate, and each semiconductor pillar comprises the first part and the second part on the first part, so that the maximum diameter width of the first part is less than the minimum diameter width of the second part; then, the first parts of the plurality of semiconductor pillars are all oxidized into the oxide pillars through oxidation treatment, and the gap between the oxide pillars is filled with the first insulating material. Finally, the corresponding active pillar is formed on the top surface of each oxide pillar, so that the active pillar is insulated from the substrate. Accordingly, the storage structure formed on part of the side wall of the active pillar is insulated from the substrate, so as to improve the problem of electric leakage of the storage structure and thus improve the reliability of the memory.

## Claims

1. A semiconductor structure, comprising:
a substrate, a plurality of oxide pillars, a plurality of active pillars, a first insulating layer and a storage structure;
wherein the plurality of oxide pillars are provided on the substrate and arranged in an array along a first direction and a second direction; both the first direction and the second direction being parallel to a surface of the substrate, and the first direction intersecting with the second direction;
the first insulating layer is located in a gap between the plurality of oxide pillars;
each of the active pillars is provided on a top surface of a corresponding one of the oxide pillars; and
the storage structure covers at least part of a side wall of the active pillar.

2. The semiconductor structure of claim 1, wherein the material of the oxide pillar is the same as or different from the material of the first insulating layer.

3. The semiconductor structure of claim 1, wherein each of the active pillars comprises a first sub-active-pillar and a second sub-active-pillar on the first sub-active-pillar; and an orthographic projection of the first sub-active-pillar on the substrate is within an orthographic projection of the second sub-active-pillar on the substrate.

4. The semiconductor structure of claim 3, wherein the storage structure comprises:
a first conductive layer, covering a side wall of the first sub-active-pillar;
a dielectric layer, covering a surface of the first conductive layer and a top surface of the first insulating layer; and
a second conductive layer, located in the dielectric layer.

5. The semiconductor structure of claim 3, further comprising: a plurality of transistors; wherein a channel structure of each of the transistors is within the second sub-active-pillar, and the channel structure extends in a direction perpendicular to the surface of the substrate.

6. The semiconductor structure of claim 5, wherein each of the transistors comprises:
a gate structure arranged around the second sub-active-pillar; and
a source and a drain respectively arranged at two opposite ends of the second sub-active-pillar.

7. The semiconductor structure according to claim 6, further comprising:
a plurality of bit lines, located on the transistors and in electrical contact with tops of the second sub-active-pillars.

8. A memory, comprising: one or more semiconductor structures of any one of claims 1 to 7.

9. A method for manufacturing a semiconductor structure, comprising:
forming on a substrate a plurality of semiconductor pillars arranged in an array along a first direction and a second direction; each of the semiconductor pillars comprising a first part and a second part on the first part; wherein a maximum diameter width of the first part is less than a minimum diameter width of the second part; both the first direction and the second direction are parallel to a surface of the substrate, and the first direction intersects with the second direction;
forming on tops of the semiconductor pillars a support layer covering a side wall of a top region of each of the second parts;
oxidizing the semiconductor pillars, so that the first parts are completely oxidized into oxide pillars, and exposed surfaces of the second parts are oxidized to form an oxide layer;
filling a first insulating material in a gap between the oxide pillars, to form a first insulating layer on the surface of the substrate;
removing the oxide layer to obtain first sub-active-pillars; and
forming a storage structure at least on a side wall of the first sub-active-pillar.

10. The method for manufacturing the semiconductor structure of claim 9, wherein forming on the substrate the plurality of semiconductor pillars arranged in the array along the first direction and the second direction comprises:
providing a semiconductor base;
forming in the base a plurality of first trenches spaced along the first direction and a plurality of second trenches spaced along the second direction; and
enlarging a bottom of each of the first trenches and/or a bottom of each of the second trenches to form the plurality of semiconductor pillars.

11. The method for manufacturing the semiconductor structure of claim 9, wherein forming the support layer comprises: filling the first insulating material between the plurality of semiconductor pillars, removing by etching part of the first insulating material, and exposing tops of the semiconductor pillars, to obtain second sub-active-pillars; and
depositing a second insulating material covering surfaces of the second sub-active-pillars to form a second insulating layer on tops of the semiconductor pillars.

12. The method for manufacturing the semiconductor structure of claim 11, comprising removing part of the second insulating layer in the second direction to form first shallow trenches each having a bottom surface flush with a bottom surface of the second sub-active-pillar, and filling the first insulating material in the first shallow trenches;
removing part of the second insulating layer in the first direction to form second shallow trenches each having a bottom surface flush with a top surface of the second sub-active-pillar, and filling the second insulating material in the second shallow trenches; and
removing all the first insulating material filled between the semiconductor pillars, and forming a grid-like support layer on the tops of the semiconductor pillars.

13. The method for manufacturing the semiconductor structure of claim 12, comprising oxidizing the semiconductor pillars after forming the support layer, so that the first parts of the semiconductor pillars are completely oxidized into oxide pillars, and exposed surfaces of the second parts of the semiconductor pillars are oxidized to form an oxide layer;
then filling the first insulating material between the semiconductor pillars and removing, by etching, part of the first insulating material and the oxide layer, wherein the remaining first insulating material and the oxide pillars form a first insulating layer on the surface of the substrate.

14. The method for manufacturing the semiconductor structure of claim 11, wherein forming the storage structure at least on the side wall of the first sub-active-pillar comprises:
forming a first conductive layer covering the side wall of the first sub-active-pillar;
forming a dielectric layer covering a surface of the first conductive layer and a top surface of the first insulating layer; and
forming a second conductive layer in the dielectric layer.

15. The method for manufacturing the semiconductor structure of claim 14, wherein,
forming the first conductive layer covering the side wall of the first sub-active-pillar comprises:
forming the first conductive layer covering the side wall of the first sub-active-pillar by a selective deposition process.

16. The method for manufacturing the semiconductor structure of claim 15, further comprising:
removing the support layer to expose the second sub-active-pillars;
forming a gate structure covering at least one side of each of the second sub-active-pillars; and
forming a source and a drain respectively at two opposite ends of the second sub-active-pillar.

17. The method for manufacturing the semiconductor structure of claim 10, wherein a maximum diameter width of the first part along the first direction is less than a minimum diameter width of the second part along the first direction;
and/or,
a maximum diameter width of the first part along the second direction is less than a minimum diameter width of the second part along the second direction.
